# EUROPÄISCHE PATENTSCHRIFT

(11) **EP 3 107 113 B1**
(45) Veröffentlichungstag und Bekanntmachung des Hinweises auf die Patenterteilung: **09.01.2019**
(21) Anmeldenummer: 16172771.4
(22) Anmeldetag: 03.06.2016
(51) Int. Cl.: H01J 37/317, H01J 37/02

(54) **KORPUSKULARSTRAHLGERÄT UND VERFAHREN ZUM BETREIBEN EINES KORPUSKULARSTRAHLGERÄTS**
CORPUSCULAR BEAM DEVICE AND METHOD FOR OPERATING A CORPUSCULAR BEAM DEVICE
APPAREIL D'IRRADIATION CORPUSCULAIRE ET PROCÉDÉ D'EXPLOITATION D'UN APPAREIL D'IRRADIATION CORPUSCULAIRE

(30) Priorität: 17.06.2015 DE 102015211090
(43) Veröffentlichungstag der Anmeldung: 21.12.2016
(73) Patentinhaber: Vistec Electron Beam GmbH, 07743 Jena (DE)
(72) Erfinder: BORSCHEL, Christian, 07743 Jena (DE)
(74) Vertreter: Hofmann, Ernst

(56) Entgegenhaltungen:
- DE-A1-102005 031 792
- DE-A1-102008 049 655
- DE-A1-102009 033 319
- WANZENBOECK H ET AL: "Novel method for cleaning a vacuum chamber from hydrocarbon contamination", JOURNAL OF VACUUM SCIENCE AND TECHNOLOGY: PART A, AVS /AIP, MELVILLE, NY., US, Bd. 28, Nr. 6, 1. November 2010 (2010-11-01), Seiten 1413-1420, XP012143791, ISSN: 0734-2101, DOI: 10.1116/1.3484242
- Kohli ET AL: "Chapter | 2 Plasma Cleaning", Elsevier Science & Technology, 1 January 2012 (2012-01-01), XP055457940, Retrieved from the Internet: URL:-
- -: "Scanning Electron Microscope VEGA II LSH, Instruction for use", , 9 March 2018 (2018-03-09), XP055457974, Retrieved from the Internet: URL:https://engineering.tamu.edu/media/324 7232/VEGA_II_Manual-eng-.pdf [retrieved on 2018-03-09]
- LYDIA-MARIE JOUBERT: "Plasma cleaning for biological fe-sem - High-resolution imaging with field-emission SEM: the need for downstream plasma cleaning in biological applications", MICROSCOPY AND ANALYSIS, vol. 27, no. 4, May 2013 (2013-05), pages 15,17--18, 20, XP055457903,

## Beschreibung

### GEBIET DER TECHNIK

Die vorliegende Erfindung betrifft ein Korpuskularstrahlgerät sowie ein Verfahren zum Betreiben eines Korpuskularstrahlgeräts und insbesondere eine Möglichkeit zur Reinigung derartiger Geräte.

### STAND DER TECHNIK

Bekannte Korpuskularstrahlgeräte, beispielsweise Elektronenstrahlschreiber, umfassen eine Säule mit einer Korpuskularstrahl-Optik, um darüber in einem Belichtungsbetrieb in einer Vakuum-Probenkammer ein gewünschtes Muster zu belichten. Im Verlauf der Betriebsdauer lagern sich dabei organische Verunreinigungen auf Oberflächen von Bauteilen in der Säule und/oder der Vakuum-Probenkammer ab, beispielsweise auf Blenden oder auf Elektroden elektrostatischer Ablenksysteme. Diese Verunreinigungen stammen z.B. aus den für die Lithographieprozesse erforderlichen Lacken auf den Substraten in der Vakuum-Probenkammer. Aus den Lacken werden durch den Beschuss mit Korpuskularstrahlen wir z.B. Elektronen organische Moleküle ausgelöst, die abdampfen, aus der Vakuum-Probenkammer in die Säule diffundieren und auf Bauteil-Oberflächen in der Säule adsorbieren können. Durch den Beschuss mit geladenen Teilchen werden die Moleküle zerlegt und verlinkt, so dass sich auf den Bauteil-Oberflächen feste, kohlenstoffreiche Kontaminationsschichten bilden, die nicht mehr desorbieren. Die Kontaminationsschichten weisen eine schlechte elektrische Leitfähigkeit auf und können sich durch die darauf auftreffenden Primär- und Sekundärelektronen stark aufladen. Bei wechselnden Bedingungen in der Säule werden die Kontaminationsschichten dann langsam aufgeladen oder entladen. Die zeitlich veränderlichen Ladungen in den Kontaminationsschichten erzeugen im Belichtungsbetrieb somit zeitlich veränderliche elektrostatische Felder. Derartige Felder wiederum lenken den Korpuskularstrahl in der Säule unerwünscht ab und führen z.B. zu unkontrollierbarem Driften der Strahlposition auf dem Substrat oder beeinflussen andere Strahleigenschaften in unkontrollierbarer Weise. Es ist in derartigen Geräten daher eine regelmäßige Reinigung der entsprechend anfälligen Oberflächen in der Säule bzw. in der Vakuum-Probenkammer erforderlich, um diese negativen Einflüsse von Verunreinigungen zu vermeiden oder zumindest zu minimieren. Neben dem zeitaufwändigen Ausbau entsprechender Komponenten und dem Reinigen derselben sind verschiedene Verfahren bekannt, entsprechende Kontaminationen zu entfernen, ohne dass die Säule des Korpuskularstrahlgeräts demontiert werden muss.

In der DE 100 57 079 A1 wird etwa vorgeschlagen, in die Kammern der Säule während der Belichtung Ozon einzuführen. Durch den Beschuss mit Elektronen wird das Ozon in Sauerstoff und Sauerstoffradikale aufgespalten. Die Sauerstoffradikale reagieren dann mit Verschmutzungen an Bauteil-Oberflächen in der Säule und die dabei resultierenden Reaktionsprodukte werden abgepumpt. Nachteilig an diesem Verfahren ist, dass darüber eine räumlich gezielte Reinigung bestimmter Bauteile in der Säule kaum möglich ist. Ferner ist die Einstellung eines passenden Ozon-Drucks in allen Bereichen der Säule schwierig, wenn gleichzeitig im Belichtungsbetrieb das erforderliche Hochvakuum aufrechterhalten werden muss.

Eine weitere Art von Reinigungsverfahren für die Säule eines Korpuskularstrahlgeräts ist aus den Druckschriften DE 10 2008 049 655 A1 bzw. US 6,207,117 B1 bekannt. Dabei werden in der Säule im Bereich der verschmutzungsanfälligen Bauteile katalytische Materialien angebracht und über ein Gaszuführsystem eine aktivierbare Substanz in die Säule eingeführt. Nach der Aktivierung der eingebrachten Substanz über die katalytischen Materialien wechselwirkt die aktivierte Substanz dann mit dem vorhandenen Kontaminationsmaterial und die dabei entstehenden Reaktionsprodukte können abgepumpt werden. Die Aktivierung der eingebrachten Substanz kann hierbei alternativ bzw. unterstützend über eine Beleuchtung mit UV-Strahlung erfolgen, wozu in der Säule eine entsprechende UV-Lichtquelle angeordnet bzw. in die Säule einbringbar ist. Auch bei diesen Verfahren ist eine gezielte Beseitigung von Verunreinigungen auf bestimmten Bauteilen kaum möglich, insbesondere kann die Reinigung nicht bedarfsgerecht lokal gesteuert werden.

Die DE 10 2009 033 319 A1 offenbart eine Möglichkeit zur Reinigung innerer Oberflächen eines Partikelstrahlsystems. Hierzu wird ein Precursor-Gas in eine Vakuumkammer eingeführt und in der Nähe der zu reinigenden Oberflächen durch elektromagnetische Strahlung aktiviert und in ein Reaktivgas umgewandelt. Das Reaktivgas reagiert mit den an den bestrahlten Oberflächen adsorbierten Verunreinigungen, so dass diese von den Oberflächen desorbieren und abgepumpt werden können. Zur Anregung des Precursor-Gases innerhalb der Vakuumkammer und in der Nähe der Oberflächen, an denen Verunreinigung adsorbiert sind, umfasst das Partikelstrahlsystem eine oder mehrere Quellen elektromagnetischer Strahlung.

### ZUSAMMENFASSUNG DER ERFINDUNG

Der vorliegenden Erfindung liegt die Aufgabe zugrunde, ein Korpuskularstrahlgerät sowie ein Verfahren zum Betreiben eines Korpuskularstrahlgeräts anzugeben, über das eine gezielte und effiziente Reinigung von Bauteil-Oberflächen in der Säule und/oder in der Vakuum-Probenkammer eines derartigen Geräts möglich ist.

Diese Aufgabe wird erfindungsgemäß durch ein Korpuskularstrahlgerät mit den Merkmalen des Anspruchs 1 gelöst.

Vorteilhafte Ausführungsformen des erfindungsgemäßen Korpuskularstrahlgeräts ergeben sich aus den Maßnahmen, die in den von Anspruch 1 abhängigen Ansprüchen aufgeführt sind.

Das erfindungsgemäße Korpuskularstrahlgerät umfasst
- eine Säule, die eine Korpuskularstrahl-Optik zur Erzeugung eines Korpuskularstrahls aufweist, um darüber in einem Belichtungsbetrieb in einer Vakuum-Probenkammer ein gewünschtes Muster zu belichten,
- ein Gaszuführsystem, um darüber in einem Reinigungsbetrieb der Säule und/oder der Vakuum-Probenkammer einen regulierbaren Gasstrom mit einem photodissoziierbaren Gas zuzuführen und
- mehrere Lichtquellen, die räumlich verteilt in der Säule und/oder in der Vakuum-Probenkammer angeordnet sind und im Reinigungsbetrieb eine Photodissoziation des zugeführten Gases bewirken und
- eine mit den Lichtquellen verbundene Steuereinheit, die derart ausgebildet ist, dass darüber im Reinigungsbetrieb einzelne Lichtquellen zeitlich selektiv ein- und ausschaltbar sind.

Desweiteren ist außerhalb der Säule ein Sauerstoff-Reservoir sowie ein Ozon-Generator angeordnet, über den aus dem Sauerstoff-Reservoir Ozon als photodissoziierbares Gas erzeugbar und der Säule über das Gaszuführsystem zuführbar ist und wobei durch die Wechselwirkung zwischen der von den Lichtquellen emittierten Strahlung und dem Ozon Sauerstoffradikale als Photodissoziationsprodukte resultieren, die mit Verunreinigungen zu abpumpbaren Abbauprodukten reagieren.

In einer vorteilhaften Ausführungsform steht die Steuereinheit desweiteren mit einem Einlassventil des Gaszuführsystems in Wirkverbindung und ist derart ausgebildet, dass durch Einwirkung auf das Einlassventil der Gasdruck in der Säule und/oder in der Vakuum-Probenkammer im Reinigungsbetrieb gezielt einstellbar ist.

Hierbei kann für definierte räumliche Bereiche der Säule und/oder der Vakuum-Probenkammer in der Steuereinheit jeweils ein Parametersatz abgelegt werden, der die erforderlichen Parameter zur optimalen Reinigung des jeweiligen Bereiches enthält und wobei der Parametersatz mindestens die Auswahl einer oder mehrerer bestimmter Lichtquellen, deren Einschaltzeiten und einen bestimmten Gasdruck in der Säule und/oder in der Vakuum-Probenkammer umfasst.

Es ist ferner möglich, dass die Vakuum-Probenkammer mit einer Vakuumpumpe in Wirkverbindung steht, um resultierende Abbauprodukte aus der Reaktion der Photodissoziationsprodukte mit Verunreinigungen abzupumpen und zwischen der Vakuum-Probenkammer und der Vakuumpumpe eine Umwandlungseinheit angeordnet ist, die noch im Abpump-Gasstrom befindliche Reste des photodissoziierbaren Gases abbaut.

Mit Vorteil ist in der Säule eine Korpuskularstrahlquelle angeordnet, der eine Schutz-Blende vorgeordnet ist, um die Korpuskularstrahlquelle vor einer Rückdiffusion von Photodissoziationsprodukten zu schützen.

Es ist ferner vorteilhaft, dass die Lichtquellen in der Säule und/oder in der Vakuum-Probenkammer jeweils benachbart zu Elementen angeordnet sind, die zur organischen Kontamination neigen.

In einer möglichen Ausführungsform sind die Lichtquellen jeweils als LEDs ausgebildet, die im ultravioletten Spektralbereich zwischen 200 nm und 300 nm emittieren.

Alternativ kann auch vorgesehen sein, dass die mehreren Lichtquellen als Austrittsflächen eines Faserbündels mit mehreren Lichtleitfasern ausgebildet und räumlich verteilt in der Säule und/oder in der Vakuum-Probenkammer platziert sind und am anderen Ende des Faserbündels eine Lichtquelle angeordnet ist, über die eine Einkopplung von Licht in die einzelnen Lichtleitfasern des Faserbündels erfolgt und wobei zwischen der Lichtquelle und den Lichtleitfasern mindestens eine faseroptische Schalteinheit angeordnet ist, die über die Steuereinheit zum zeitlich selektiven Ein- und Ausschalten einzelner Lichtleitfasern betätigbar ist.

Des Weiteren wird die Aufgabe durch ein Verfahren zum Betreiben eines Korpuskularstrahlgeräts mit den Merkmalen des Anspruchs 9 gelöst.

Vorteilhafte Ausführungsformen des erfindungsgemäßen Verfahrens ergeben sich aus den Maßnahmen, die in den von Anspruch 9 abhängigen Ansprüchen aufgeführt sind.

Das erfindungsgemäße Verfahren zum Betreiben eines Korpuskularstrahlgeräts mit einer Säule, die eine Korpuskularstrahl-Optik umfasst, um darüber in einem Belichtungsbetrieb in einer Vakuum-Probenkammer ein gewünschtes Muster zu belichten, sieht vor, dass
- zur Reinigung der Säule und/oder der Vakuum-Probenkammer in einem Reinigungsbetrieb über ein Gaszuführsystem der Säule und/oder der Vakuum-Probenkammer ein regulierbarer Gasstrom mit einem photodissoziierbarem Gas zugeführt wird und
- im Reinigungsbetrieb das zugeführte Gas mittels mehrerer in der Säule und/oder in der Vakuum-Probenkammer räumlich verteilt angeordneter Lichtquellen photodissoziiert wird, indem einzelne Lichtquellen über eine damit verbundene Steuereinheit zeitlich selektiv ein- und ausgeschaltet werden,
wobei außerhalb der Säule ein Sauerstoff-Reservoir sowie ein Ozon-Generator angeordnet ist, über den aus dem Sauerstoff-Reservoir Ozon als photodissoziierbares Gas erzeugt und der Säule über das Gaszuführsystem zugeführt wird und wobei durch die Wechselwirkung zwischen der von den Lichtquellen emittierten Strahlung und dem Ozon Sauerstoffradikale als Photodissoziationsprodukte resultieren, die mit Verunreinigungen zu abpumpbaren Abbauprodukten reagieren.

Es ist ferner möglich, dass die Steuereinheit mit einem Einlassventil des Gaszuführsystems in Wirkverbindung steht und im Reinigungsbetrieb derart auf das Einlassventil einwirkt, dass der Gasdruck in der Säule und/oder in der Vakuum-Probenkammer definiert eingestellt wird.

Desweiteren kann vorgesehen sein, dass über die Steuereinheit im Reinigungsbetrieb die zeitliche Aktivierung einzelner Lichtquellen in Abhängigkeit von der Verschmutzung in der Umgebung der jeweiligen Lichtquelle vorgenommen wird.

Mit Vorteil wird während des Reinigungsbetriebs der Korpuskularstrahl ausgeschaltet.

In einer möglichen Ausführungsform werden die aus der Reaktion der Photodissoziationsprodukte mit Verunreinigungen resultierenden Abbauprodukte über eine Vakuumpumpe abgesaugt.

Hierbei kann noch zusätzlich vorgesehen werden, dass die noch im Abpump-Gasstrom befindlichen Reste des photodissoziierbaren Gases abgebaut werden.

Als besonders vorteilhaft erweist sich beim erfindungsgemäßen Korpuskularstrahlgerät bzw. erfindungsgemäßen Verfahren, dass im Reinigungsbetrieb aufgrund der Verwendung einer Vielzahl von zeitlich selektiv ein- und ausschaltbaren Lichtquellen eine gezielte lokale Reinigung von besonders kontaminierten Elementen bzw. Bereichen in der Säule und/oder der Vakuum-Probenkammer des Korpuskularstrahlgeräts erfolgen kann. Eine Demontage des Gesamtsystems ist dazu nicht nötig, d.h. die für den Reinigungsbetrieb resultierende Stillstandszeit des Geräts kann deutlich verkürzt werden. Aufgrund der geschaffenen Möglichkeit zur gezielten lokalen Reinigung betroffener Elemente lässt sich weiterhin die Belastung anderer, unkontaminierter Komponenten in der Säule und/oder in der Vakuum-Probenkammer weitgehend minimieren.

Der Ort der Erzeugung von Abbauprodukten des photodissoziierbaren Gases und die Reichweite dieser Abbauprodukte in der Säule und/oder in der Vakuum-Probenkammer lassen sich unabhängig voneinander gut über die vorgesehene Steuereinheit kontrollieren. Dies erfolgt zum einen durch die gezielte Auswahl der im Reinigungsbetrieb jeweils einzuschaltenden Lichtquelle(n), zum anderen durch die Einwirkung auf Einlassventil und den darüber einstellbaren Druck in der Säule und/oder in der Vakuum-Probenkammer. Auf diese Art und Weise können für jeden zu reinigenden Säulenabschnitt bzw. jeden Bereich der Vakuum-Probenkammer unabhängig voneinander optimale Parameter gewählt werden.

Weitere Einzelheiten und Vorteile der vorliegenden Erfindung seien anhand der nachfolgenden Beschreibung von Ausführungsbeispielen der erfindungsgemäßen Vorrichtung und des erfindungsgemäßen Verfahrens in Verbindung mit den Figuren erläutert.

### KURZE BESCHREIBUNG DER ZEICHNUNGEN

Es zeigt
- Figur 1: eine stark schematisierte Darstellung eines ersten Ausführungsbeispiels eines erfindungsgemäßen Korpuskularstrahlgeräts;
- Figur 2: ein Flussdiagramm zur Erläuterung des erfindungsgemäßen Verfahrens;
- Figur 3: eine stark schematisierte Darstellung eines zweiten Ausführungsbeispiels eines erfindungsgemäßen Korpuskularstrahlgeräts.

### BESCHREIBUNG DER AUSFÜHRUNGSFORMEN

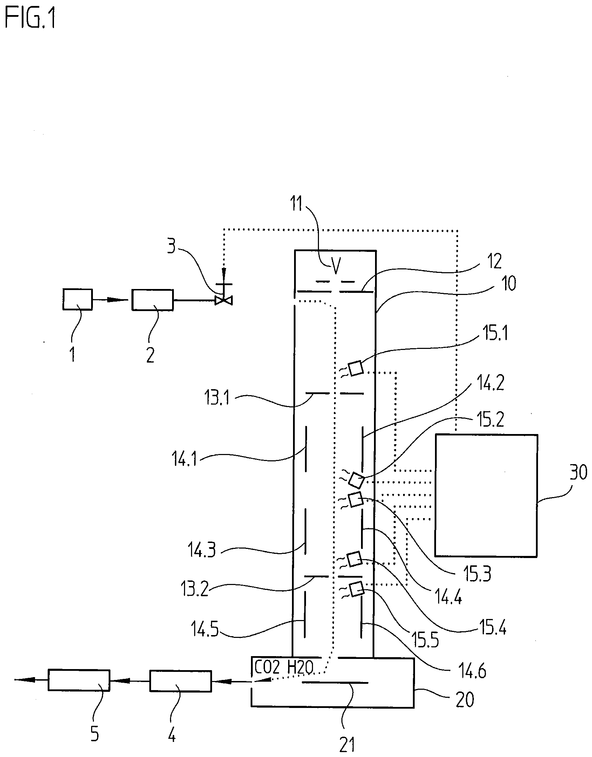

Ein erstes Ausführungsbeispiel des erfindungsgemäßen Korpuskularstrahlgeräts wird nachfolgend anhand der stark schematisierten Darstellung in Figur 1 erläutert.

In diesem als auch in den weiteren Ausführungsbeispielen ist das erfindungsgemäße Korpuskularstrahlgerät jeweils als Elektronenstrahlschreiber ausgebildet; grundsätzlich kann die vorliegende Erfindung aber selbstverständlich auch in Verbindung mit anderen Korpuskularstrahl-Systemen eingesetzt werden wie etwa Ionenstrahlgeräten, Elektronenstrahlmikroskopen etc..

Das erfindungsgemäße Korpuskularstrahlgerät umfasst eine Säule 10 mit einer Korpuskularstrahl-Optik zur Erzeugung eines Korpuskularstrahls, respektive eines Elektronenstrahls, um darüber in einem Belichtungsbetrieb in der Vakuum-Probenkammer 20 ein gewünschtes Muster auf einem Substrat 21 zu schreiben. Zur Korpuskularstrahl-Optik gehören neben einer in der Säule 10 angeordneten Korpuskularstrahlquelle 11 u.a. verschiedene Blenden 13.1, 13.2 sowie elektrostatische Ablenkelektroden 14.1 - 14.6, die in der Figur lediglich stark schematisiert angedeutet sind. Über diese Elemente erfolgt in der Säule 10 in prinzipiell bekannter Art und Weise die Formung und Ablenkung des von der Korpuskularstrahlquelle 11 erzeugten Korpuskularstrahls im Belichtungsbetrieb.

Zum erfindungsgemäßen Korpuskularstrahlgerät gehört ferner ein Gaszuführsystem, das i.w. ein regelbares Einlassventil 3 sowie eine Verbindungsleitung zwischen dem Einlassventil 3 und der Säule 10 umfasst. Über das Gaszuführsystem wird beispielsweise dem oberen Ende der Säule 10 in einem Reinigungsbetrieb ein regulierbarer Gasstrom mit einem photodissoziierbaren Gas zugeführt und durch die Säule 10 geleitet; in Figur 1 ist der entsprechende Gasstrom in der Säule 10 als gepunktete Linie angedeutet. Selbstverständlich kann alternativ auch an anderer Stelle der Säule 10 ein derartiger Gasstrom zugeführt werden.

In der vorliegenden Erfindung handelt es sich beim photodissoziierbaren Gas um Ozon (O₃), das in einem Ozon-Generator 2 erzeugt und dann dem Gaszuführsystem zugeführt wird. Zur Ozon-Erzeugung wird dem Ozon-Generator 2 dabei molekularer Sauerstoff (O₂) aus einem Sauerstoff-Reservoir 1 zugeleitet, im Ozon-Generator 2 erfolgt die Ozon-Erzeugung dann in bekannter Art und Weise, beispielsweise durch stille elektrische Entladung nach dem Siemens-Prinzip.

Das der Säule 10 derart zugeführte Ozon (O₃) wird im Reinigungsbetrieb dann in der Säule 10 und/oder in der Vakuum-Probenkammer 20 photodissoziiert, d.h. über die lokale Einwirkung ultravioletter Strahlung in Photodissoziationsprodukte in Form von Sauerstoff-Molekülen (O₂) und Sauerstoff-Radikalen (O⁻) aufgespalten. Die Sauerstoff-Radikale (O⁻) fungieren in der Säule 10 und/oder in der Vakuum-Probenkammer 20 dann als Oxidatoren, über die organische, kohlenstoffreiche Verunreinigungen an verschiedenen Elementen des Systems durch Oxidation abgebaut werden können. Aus der Oxidationsreaktion zwischen den Sauerstoffradikalen (O⁻) und den organischen Verunreinigungen resultieren u.a. Kohlendioxid (CO₂) und Wasser (H₂O) als flüchtige Reaktions- bzw. Abbauprodukte, die den Gasstrom in der Säule 10 anreichern und schließlich am unteren Ende der Säule 20 bzw. über die Vakuum-Probenkammer 20 wie in Figur 1 angedeutet abgepumpt werden; das Abpumpen kann dabei selbstverständlich auch an einer anderen geeigneten Stelle des erfindungsgemäßen Korpuskularstrahlgeräts erfolgen.

Um die Korpuskularstrahlquelle 11 in der Säule vor einer Rückdiffusion von Photodissoziationsprodukten, insbesondere Sauerstoffradikalen (O⁻), zu schützen, erweist es sich als vorteilhaft, wenn vor der Korpuskularstrahlquelle 11 eine Schutz-Blende 12 mit einer engen Blendenöffnung angeordnet wird. Auf diese Art und Weise lässt sich ein ggf. erhöhter Verschleiß der Korpuskularstrahlquelle 11 durch zusätzliche Oxidationsprozesse vermeiden.

Zum Abpumpen der bei der Oxidation resultierenden Abbauprodukte Kohlendioxid (CO₂) und Wasser (H₂O) dient im Reinigungsbetrieb eine Vakuumpumpe 5, welche in Figur 1 lediglich schematisiert angedeutet ist; diese Pumpe wird im Belichtungsbetrieb dazu verwendet, das System zu evakuieren und das erforderliche Hochvakuum zu erzeugen. Typischerweise werden als geeignete Vakuumpumpe 5 Kombinationen aus mechanischen Vorpumpen wie Drehschieber- oder Scroll-Pumpen und einer Turbomolekularpumpe eingesetzt, d.h. die Vakuumpumpe 5 stellt in der Regel ein Pumpensystem aus mehreren aufeinander abgestimmten einzelnen Pumpen dar.

Zwischen der Vakuum-Probenkammer 20 und der Vakuumpumpe 5 ist im vorliegenden Ausführungsbeispiel noch eine Umwandlungseinheit 4 in Form eines Ozon-Vernichters im Abpump-Gasstrom angeordnet. Über die Umwandlungseinheit 4 werden eventuell noch im Abpump-Gasstrom befindliche Reste des photodissoziierbaren Gases, respektive Ozon (O₃), abgebaut, um Umwelt- und/oder Gesundheitsrisiken zu vermeiden. Ein derartiger Abbau von Rest-Ozon (O₃) kann in der Umwandlungseinheit 4 etwa durch die Bestrahlung mit intensivem UV-Licht der Wellenlänge 250nm oder aber über Edelmetallkatalysatoren erfolgen.

Um in der elektronenoptischen Säule 10 und/oder ggf. in der Vakuum-Probenkammer 20 den erforderlichen Gasdruck für den Reinigungsbetrieb, z.B. im Bereich zwischen 1 - 100 Pa, gezielt einzustellen, wird bei gegebener Pumpleistung der Vakuumpumpe 5 über das regelbare Einlassventil 3 die erforderliche - üblicherweise geringe - Menge des photodissoziierbaren Gases Ozon (O₃) in die Säule 10 eingelassen. Hierzu steht das Einlassventil 3 in Wirkverbindung mit der Steuereinheit 30, die in geeigneter Art und Weise das Einlassventil 3 betätigt bzw. darauf einwirkt.

Im erfindungsgemäßen Korpuskularstrahlgerät ist demzufolge neben dem eigentlichen Belichtungsbetrieb ein separater Reinigungsbetrieb vorgesehen, in dem auf die vorstehend erläuterte Art und Weise eine gezielte, räumlich selektive Reinigung organisch kontaminierter Elemente in der Säule 10 und/oder in der Vakuum-Probenkammer 20 erfolgt.

Maßgeblich für die vorliegende Erfindung ist dabei, dass in der Säule 10 und/oder in der Vakuum-Probenkammer 20 mehrere Lichtquellen 15.1 - 15.5 räumlich verteilt angeordnet sind, über die die Photodissoziation des zugeführten Gases bzw. Ozons (O₃) bewirkt wird und die über die Steuereinheit 30 zeitlich selektiv ein- und ausschaltbar sind. Die Lichtquellen 15.1 - 15.5 sind im dargestellten Ausführungsbeispiel hierzu jeweils benachbart zu Elementen in der Säule 10 des Korpuskularstrahlgeräts angeordnet, die zur organischen Kontamination neigen; beispielsweise ist die Lichtquelle 15.1 in der Nähe der Blende 13.1 platziert, die Lichtquelle 15.2 in der Nähe der elektrostatischen Ablenkelektroden 14.1 und 14.2 usw.. Selbstverständlich ist die in Figur 1 gezeigte Anordnung von fünf Lichtquellen 15.1 - 15.5 benachbart zu bestimmten Blenden 13.1, 13.2 und Ablenkelektroden 14.1 - 14.6 lediglich beispielhaft zu verstehen, d.h. es kann natürlich auch eine größere oder kleinere Anzahl von Lichtquellen 15.1 - 15.5 in der Säule 10 und/oder auch in der Vakuum-Probenkammer 20 vorgesehen sein; zudem können diese auch an anderen Orten in der Säule 10 und/oder in der Vakuum-Probenkammer 20 platziert werden, die kontaminationsanfällig sind. In Fall der Vakuum-Probenkammer 20 kann es sich beispielsweise um - nicht in der Figur dargestellte - Strahl-Detektoren oder passive Elemente handeln, die derart gereinigt werden.

Auf diese Art und Weise ist es erfindungsgemäß möglich, in unmittelbarer Nähe der kontaminierten Elemente in der Säule 10 und/oder in der Vakuum-Probenkammer 20 den Ozonstrom durch Bestrahlung mit ultravioletter Strahlung zu aktivieren und lokal gezielt eine hinreichend große Anzahl von Sauerstoffradikalen (O⁻) zu erzeugen, die dann mit den organischen Verunreinigungen auf den entsprechenden Elementen zu den verschiedenen flüchtigen Abbauprodukten Kohlendioxid (CO₂) bzw. Wasser (H₂O) reagieren. Die Anordnung der Lichtquellen 15.1 - 15.5 in unmittelbarer Nachbarschaft zu den entsprechenden Elementen bzw. in Bereichen der Säule 10 und/oder der Vakuum-Probenkammer 20 hat ferner zur Folge, dass durch die UV-Bestrahlung direkt Moleküle in den Kontaminationsschichten angeregt oder aktiviert werden können und sich dadurch noch leichter über die Sauerstoffradikale (O⁻) oxidieren und damit entfernen lassen. Einige organische Moleküle können dabei sogar durch die bloße Bestrahlung mit ultraviolettem Licht zu flüchtigen Molekülen dissoziiert und abgepumpt werden.

Als Lichtquellen 15.1 - 15.5 werden in diesem Ausführungsbeispiel des erfindungsgemäßen Korpuskularstrahlgeräts vorzugsweise LEDs (Light Emitting Diodes) in der Säule 10 eingesetzt, die im ultravioletten Spektralbereich zwischen 200 nm und 300 nm emittieren. Besonders geeignet erweisen sich hierbei insbesondere LEDs auf Basis von Aluminiumnitrid. Derartige LEDs besitzen Lebensdauern, welche bei Reinigungszeiten im Bereich weniger Stunden pro Monat die Lebensdauer des entsprechenden Korpuskularstrahlgeräts deutlich übersteigen. Im Bereich von etwa 250 nm absorbiert insbesondere Ozon (O₃) besonders gut ultraviolette Strahlung und lässt sich darüber leicht in Sauerstoffmoleküle (O₂) und Sauerstoffradikale (O⁻) dissoziieren.

Die Verwendung von LEDs erweist sich auch aufgrund der Kompaktheit dieser Lichtquellen 15.1 - 15.5 als äußerst vorteilhaft, da diese inklusive der erforderlichen elektrischen Zuleitungen problemlos an den erforderlichen Stellen in der Säule 10 und/oder in der Vakuum-Probenkammer 20 angeordnet werden können, ohne dass Kollisions-Probleme mit anderen in der Säule 10 und/oder in der Vakuum-Probenkammer 20 vorhandenen Komponenten resultieren. Dadurch ist es auch möglich sicherzustellen, dass primär die besonders kontaminationsgefährdeten Elemente gezielt bestrahlbar sind, während andere ggf. strahlungsempfindlichere Elemente wie z.B. Kabelisolationen von der emittierten UV-Strahlung abgeschattet werden.

Ferner können die als LEDs ausgebildeten Lichtquellen 15.1 - 15.5 auch ohne größeres Risiko im Vakuum der Säule 10 und/oder der Vakuum-Probenkammer 20 eingesetzt werden, ohne größere Gefahren für das Vakuumsystem des Gesamtsystems befürchten zu müssen.

Im Fall der Verwendung von konventionellen UV-Lichtquellen, wie etwa Quecksilberdampflampen, würden hingegen Probleme in Bezug auf die geeignete Anordnung derselbigen in der Säule 10 und/oder in der Vakuum-Probenkammer 20 resultieren, da diese deutlich größer bauen. Zudem besteht das Risiko, dass im Fall der Zerstörung derartiger Lichtquellen das Vakuumsystem des Gesamtsystems über eine resultierende Quecksilber-Kontamination unbrauchbar werden könnte.

Als weiterer Vorteil der Verwendung von Lichtquellen 15.1 - 15.5 im genannten Wellenlängenbereich ist anzuführen, dass darüber MetallOberflächen in der Säule 10 und/oder in der Vakuum-Probenkammer 20 grundsätzlich weniger stark angegriffen werden, als im Fall der Verwendung von noch kurzwelligerer Strahlung, über die z.B. Sauerstoff direkt gespalten werden könnte.

Über die Steuereinheit 30 ist es im Reinigungsbetrieb möglich, einzelne Lichtquellen 15.1 - 15.5 gezielt über eine bestimmte Zeitdauer einzuschalten und anschließend auszuschalten, d.h. diese zeitlich selektiv ein- und auszuschalten. Dies kann etwa bedeuten, dass einzelne der Lichtquellen 15.1 - 15.5 in einem bestimmten Bereich der Säule 10 und/oder in der Vakuum-Probenkammer 20 für eine bestimmte Zeitdauer eingeschaltet werden und lediglich dort die Dissoziierung des Ozon-Gasstroms und damit die lokal selektive Reinigung von Komponenten in diesem Bereich resultiert. Beispielsweise könnten dabei etwa nur die beiden Lichtquellen 15.4, 15.5 im unteren Säulenbereich für eine bestimmte Zeitdauer eingeschaltet werden, um speziell die besonders kontaminierten Ablenkelektroden 14.5, 14.6 und die Blende 13.2 zu reinigen etc.. Grundsätzlich ist es aber auch möglich, im Bedarfsfall alle Lichtquellen 15.1 - 15.5 gleichzeitig einzuschalten.

Wie bereits oben erwähnt, wirkt die Steuereinheit 30 nicht nur wie erläutert auf die Lichtquellen 15.1 - 15.5 ein, sondern steht auch in Wirkverbindung mit dem regelbaren Einlassventil 3. Dadurch ist es möglich, bei gegebener Pumpleistung der Pumpe 5 den Gasdruck des photodissoziierbaren Gases bzw. Ozons (O₃) in der Säule 10 und/oder in der Vakuum-Probenkammer 20 gezielt einzustellen. Über den Gasdruck wiederum kann die Reichweite der Reinigungswirkung des beschriebenen Reinigungsverfahrens gut eingestellt werden, da die Dichte der erzeugten Sauerstoffradikale (O⁻) durch Stöße im Gas abhängig vom Druck exponentiell mit der Entfernung vom Ort der Radikalerzeugung abnimmt.

Über die Steuereinheit 30 und deren Einwirkungsmöglichkeit auf das Einlassventil 3 und damit den Gasdruck in der Säule 10 und/oder in der Vakuum-Probenkammer 20 einerseits sowie die darüber mögliche selektive Ein- und Ausschaltbarkeit der Lichtquellen 15.1 - 15.5 andererseits lassen sich somit besonders gezielt und effizient Kontaminationen in verschiedenen Bereichen der Säule 10 und/oder in der Vakuum-Probenkammer 20 im Reinigungsbetrieb beseitigen. Hierzu können in der Steuereinheit 30 für bestimmte räumliche Bereiche der Säule 10 und/oder der Vakuum-Probenkammer 20 des Korpuskularstrahlgeräts Parametersätze für die optimale Reinigung der jeweiligen Bereiche abgelegt werden. Ein derartiger Parametersatz enthält dabei zumindest die Auswahl bestimmter Lichtquellen 15.1 - 15.5, die hierzu eingeschaltet werden müssen als auch einen bestimmten Gasdruck in der Säule 10 und/oder in der Vakuum-Probenkammer 20, der für eine lokale Reinigung dieses Bereichs als optimal ermittelt wurde. Hinzu kann des Weiteren noch eine Zeitdauer für jede ausgewählte Lichtquelle 15.1 - 15.5 kommen, über die diese idealerweise einzuschalten ist. Auf diese Art und Weise ist somit eine optimierte Reinigung unterschiedlich kontaminierter Bereiche der Säule 10 und/oder der Vakuum-Probenkammer 20 des Korpuskularstrahlgeräts möglich. Die zeitliche Aktivierung einzelner Lichtquellen 15.1 - 15.5 wird dabei grundsätzlich in Abhängigkeit von der Kontamination in der Umgebung der jeweiligen Lichtquelle 15.1 - 15.5 vorgenommen, d.h. je größer die Kontamination des zu reinigenden Elements bzw. des Bereichs in der Säule 10 und/oder der Vakuum-Probenkammer 20, desto länger wird bzw. werden in der Regel die entsprechende(n) Lichtquelle(n) eingeschaltet.

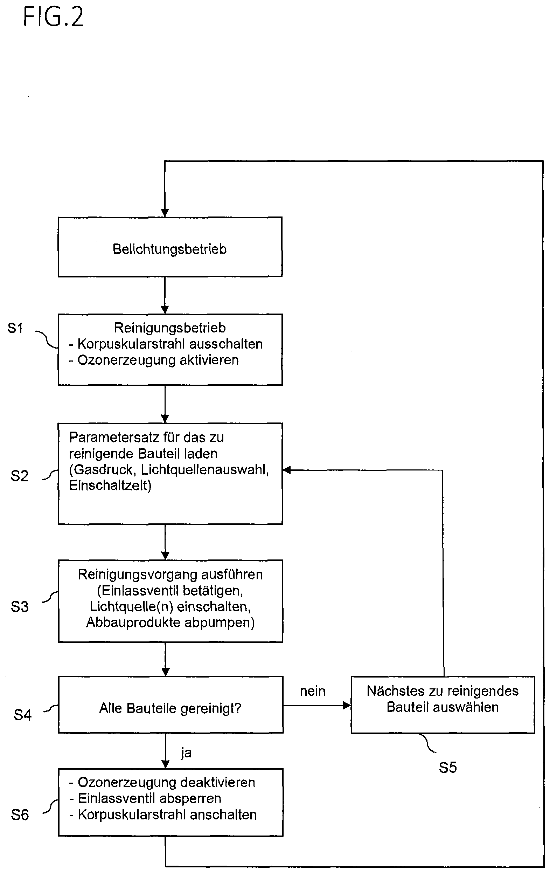

Anhand des Flussdiagramms in Figur 2 wird nachfolgend erläutert, wie in einer Ausführungsform des erfindungsgemäßen Verfahrens zum Betreiben eines Korpuskularstrahlgeräts schrittweise vorgegangen wird.

So wird aus dem Belichtungsbetrieb, in dem mit Hilfe des Korpuskularstrahls und der in der Säule angeordneten Korpuskularstrahl-Optik in der Vakuum-Probenkammer ein gewünschtes Muster auf einem Substrat belichtet wird, im Bedarfsfall in den Reinigungsbetrieb umgeschaltet, um kontaminierte Elemente in der Säule und/oder in der Vakuum-Probenkammer zu reinigen. Im ersten Verfahrensschritt S1 des Reinigungsbetriebs wird hierbei zunächst der Korpuskularstrahl ausgeschaltet und die Ozonerzeugung aktiviert. Sollten ggf. lonengetterpumpen im System vorhanden sein, erweist es sich an dieser Stelle als vorteilhaft, diese im Reinigungsbetrieb ebenfalls abzuschalten, um eine Beschädigung dieser Pumpen zu vermeiden. Anschließend erfolgt im Verfahrensschritt S2 das Laden des Parametersatzes für das ausgewählte, zu reinigende Element in der Säule und/oder in der Vakuum-Probenkammer, also z.B. einer bestimmten Blende. Zu diesem Parametersatz gehört die Auswahl eines definierten Gasdrucks in der Säule und/oder in der Vakuum-Probenkammer, die Auswahl einer oder ggf. mehrerer Lichtquellen in der Nachbarschaft des entsprechenden Elements sowie ggf. die Einschaltzeit(en) für diese Lichtquelle(n); der entsprechende optimale Parametersatz für das betreffende Element ist hierbei vorher ermittelt worden. Im folgenden Verfahrensschritt S3 wird dann der eigentliche Reinigungsvorgang durchgeführt. Dabei wird das Einlassventil geeignet betätigt, um Ozon unter geringem Druck in die Säule einzulassen, die Lichtquelle(n) über die gewünschte Zeitdauer eingeschaltet und die aus der Oxidation der Kontaminationsschichten resultierenden Abbauprodukte abgepumpt. Im anschließenden Verfahrensschritt S4 wird dann überprüft, ob alle verunreinigten Elemente in der Säule und/oder in der Vakuum-Probenkammer gereinigt sind. Ist dies nicht der Fall, wird im Verfahrensschritt S5 das nächste Element ausgewählt und die Verfahrensschritte S2 - S4 werden erneut durchgeführt, wobei natürlich der entsprechend optimierte Parametersatz für die Reinigung dieses Elements zu wählen ist. Sind auf diese Art und Weise schließlich alle kontaminierten Elemente bzw. Bereiche in der Säule und/oder in der Vakuum-Probenkammer gereinigt, wird im Verfahrensschritt S6 die Ozonerzeugung deaktiviert bzw. abgeschaltet, das Einlassventil abgesperrt und der Korpuskularstrahl sowie ggf. die lonengetterpumppen wieder angeschaltet, um das Korpuskularstrahlgerät dann wieder im herkömmlichen Belichtungsbetrieb zu betreiben.

Nach einem derartigen Reinigungsvorgang lässt sich die Säule des erfindungsgemäßen Korpuskularstrahlgeräts im Übrigen sehr schnell wieder evakuieren und in Betrieb nehmen. Dies ist möglich, da im Reinigungsbetrieb keine Belüftung der Säule bis zum Umgebungsdruck erforderlich ist und auch keine feuchte Umgebungsluft in die Säule eindringen kann. Ein ansonsten erforderliches Ausheizen von Elementen in Ultrahochvakuum-Bereichen der Säule wie z.B. der Korpuskularstrahlquelle entfällt somit.

Der beschriebene Reinigungsprozess kann sowohl in regelmäßigen Abständen oder aber nach Bedarf durchgeführt werden, wenn z.B. große Driften des Korpuskularstrahls im Belichtungsbetrieb auftreten. Es ist auch möglich, das entsprechende Reinigungsverfahren dann anzuwenden, wenn die Säule aus anderen Gründen belüftet und geöffnet werden muss, beispielsweise zum Tausch einer Säulenkomponente; auch dann lassen sich über das erfindungsgemäße Vorgehen organische Verunreinigungen an Elementen in der Säule und/oder in der Vakuum-Probenkammer rasch und gezielt abbauen.

Außer zur erläuterten Reinigung der Säule und/oder der Vakuum-Probenkammer ist es möglich, die UV-Lichtquellen auch während des Abpumpprozesses nach einem Belüftungsvorgang gezielt einzuschalten, da darüber das Ausgasverhalten bestimmter Materialien in der Säule und/oder in der Vakuum-Probenkammer beschleunigt werden kann. Auf diese Art und Weise lässt sich somit über die in der Säule und/oder in der Vakuum-Probenkammer primär für den Reinigungsbetrieb vorgesehenen Lichtquellen die Stillstandszeit des erfindungsgemäßen Korpuskularstrahlgeräts zusätzlich verringern.

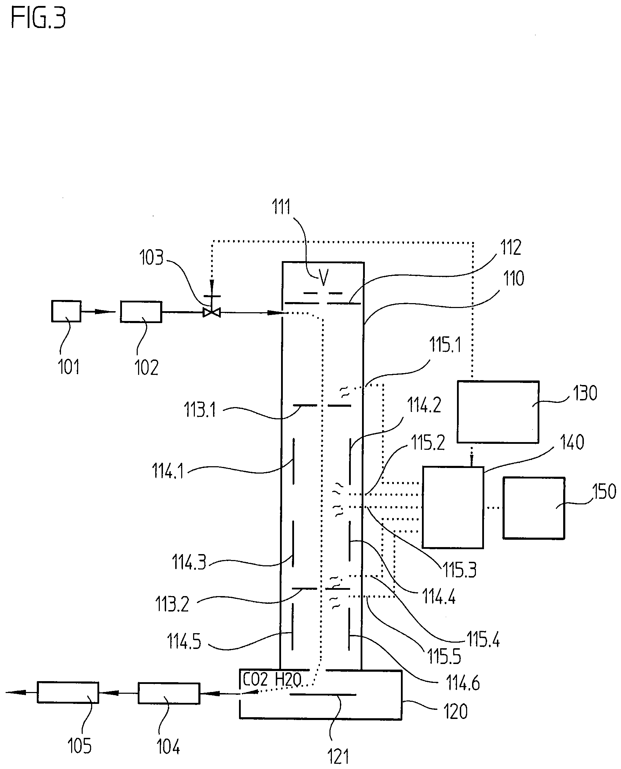

Ein zweites Ausführungsbeispiel des erfindungsgemäßen Korpuskularstrahlgeräts wird abschließend anhand der Figur 3 erläutert; hierbei wird nachfolgend lediglich auf die maßgeblichen Unterschiede zum ersten Ausführungsbeispiel eingegangen, ansonsten entspricht dieses Ausführungsbeispiel dem bereits detailliert erläuterten ersten Ausführungsbeispiel.

So unterscheidet sich das Ausführungsbeispiel aus Figur 3 primär in der Ausbildung der Mehrzahl von Lichtquellen 115.1 - 115.5 in der elektronenoptischen Säule 110 des erfindungsgemäßen Korpuskularstrahlgeräts vom Ausführungsbeispiel in Figur 1. Die Lichtquellen 115.1 - 115.5 sind vorliegend als Austrittsflächen eines Faserbündels mit mehreren Lichtleitfasern ausgebildet und räumlich verteilt in der Säule 110 platziert. Am anderen Ende des Faserbündels ist eine einzige, zentrale Lichtquelle 150 angeordnet, die wiederum ultraviolette Strahlung im Wellenlängenbereich zwischen 200 nm und 300 nm emittiert und diese Strahlung selektiv in einzelne Lichtleitfasern einkoppelt. Zwischen der Lichtquelle 150 und den mehreren Lichtleitfasern ist hierzu eine lediglich schematisiert angedeutete, in bekannter Art und Weise ausgebildete faseroptische Schalteinheit 140 in Form eines faseroptischen Multiplexers angeordnet, welche über die Steuereinheit 130 zum zeitlich selektiven Ein- und Ausschalten einzelner Lichtleitfasern und damit von Lichtquellen 115.1 - 115.5 in der Säule 110 betätigbar ist.

Die Austrittsflächen der einzelnen Lichtleitfasern sind analog zu den LED-Lichtquellen des obigen Ausführungsbeispiels wiederum in der Nähe derjenigen Elemente bzw. Bereiche in der Säule 110 des erfindungsgemäßen Korpuskularstrahlgeräts angeordnet, die zur organischen Kontamination neigen und über das erläuterte Verfahren im Reinigungsbetrieb gereinigt werden können. Selbstverständlich könnte auch in diesem Ausführungsbeispiel vorgesehen werden, die Austrittsflächen der einzelnen Lichtleitfasern benachbart zu kontaminationsanfälligen Elementen der Vakuum-Probenkammer 120 anzuordnen.

Neben den konkret beschriebenen Ausführungsbeispielen existieren im Rahmen der vorliegenden Erfindung selbstverständlich noch weitere Ausgestaltungsmöglichkeiten.

So ist es wie bereits oben angedeutet möglich, neben Elektronenstrahlschreibern auch andere Korpuskularstrahl-Systeme erfindungsgemäß auszubilden.

## Patentansprüche

1. Korpuskularstrahlgerät mit
- einer Säule (10; 110), die eine Korpuskularstrahl-Optik zur Erzeugung eines Korpuskularstrahls aufweist, um darüber in einem Belichtungsbetrieb in einer Vakuum-Probenkammer (20; 120) ein gewünschtes Muster zu belichten,
- einem Gaszuführsystem, um darüber in einem Reinigungsbetrieb der Säule (10; 110) und/oder der Vakuum-Probenkammer (20; 120) einen regulierbaren Gasstrom mit einem photodissoziierbaren Gas zuzuführen und
- mehreren Lichtquellen (15.1 - 15.5; 115.1 - 115.5), die räumlich verteilt in der Säule (10; 110) und/oder in der Vakuum-Probenkammer (20; 120) angeordnet sind und im Reinigungsbetrieb eine Photodissoziation des zugeführten Gases bewirken und
- einer mit den Lichtquellen (15.1 - 15.5; 115.1 - 115.5) verbundenen Steuereinheit (30; 130), die derart ausgebildet ist, dass darüber im Reinigungsbetrieb einzelne Lichtquellen (15.1 - 15.5; 115.1 - 115.5) zeitlich selektiv ein- und ausschaltbar sind und
- wobei außerhalb der Säule (10; 110) ein Sauerstoff-Reservoir (1; 101) sowie ein Ozon-Generator (2; 102) angeordnet ist, über den aus dem Sauerstoff-Reservoir (1; 101) Ozon als photodissoziierbares Gas erzeugbar und der Säule (10; 110) über das Gaszuführsystem zuführbar ist und wobei durch die Wechselwirkung zwischen der von den Lichtquellen (15.1 - 15.5; 115.1 - 115.5) emittierten Strahlung und dem Ozon Sauerstoffradikale als Photodissoziationsprodukte resultieren, die mit Verunreinigungen zu abpumpbaren Abbauprodukten reagieren.

2. Korpuskularstrahlgerät nach Anspruch 1, wobei die Steuereinheit (30; 130) desweiteren mit einem Einlassventil (3; 103) des Gaszuführsystems in Wirkverbindung steht und derart ausgebildet ist, dass durch Einwirkung auf das Einlassventil (3; 103) der Gasdruck in der Säule (10; 110) und/oder in der Vakuum-Probenkammer (20; 120) im Reinigungsbetrieb gezielt einstellbar ist.

3. Korpuskularstrahlgerät nach Anspruch 2, wobei für definierte räumliche Bereiche der Säule (10;110) und/oder der Vakuum-Probenkammer (20; 120) in der Steuereinheit (30; 130) jeweils ein Parametersatz abgelegt ist, der die erforderlichen Parameter zur optimalen Reinigung des jeweiligen Bereiches enthält und wobei der Parametersatz mindestens die Auswahl einer oder mehrerer bestimmter Lichtquellen (15.1 - 15.5; 115.1 - 115.5), deren Einschaltzeiten und einen bestimmten Gasdruck in der Säule (10; 110) und/oder in der Vakuum-Probenkammer (20; 120) umfasst.

4. Korpuskularstrahlgerät nach Anspruch 1, wobei die Vakuum-Probenkammer (20; 120) mit einer Vakuumpumpe (5; 105) in Wirkverbindung steht, um resultierende Abbauprodukte aus der Reaktion der Photodissoziationsprodukte mit Verunreinigungen abzupumpen und zwischen der Vakuum-Probenkammer (20; 120) und der Vakuumpumpe (5; 105) eine Umwandlungseinheit (4; 104) angeordnet ist, die noch im Abpump-Gasstrom befindliche Reste des photodissoziierbaren Gases abbaut.

5. Korpuskularstrahlgerät nach Anspruch 1, wobei dieses eine in der Säule (10; 110) angeordnete Korpuskularstrahlquelle (11; 111) aufweist, der eine Schutz-Blende (12; 112) vorgeordnet ist, um die Korpuskularstrahlquelle (11; 111) vor einer Rückdiffusion von Photodissoziationsprodukten zu schützen.

6. Korpuskularstrahlgerät nach mindestens einem der vorhergehenden Ansprüche, wobei die Lichtquellen (15.1 - 15.5; 115.1 - 115.5) in der Säule (10; 110) und/oder in der Vakuum-Probenkammer (20; 120) jeweils benachbart zu Elementen angeordnet sind, die zur organischen Kontamination neigen.

7. Korpuskularstrahlgerät nach mindestens einem der vorhergehenden Ansprüche, wobei die Lichtquellen (15.1 - 15.5) jeweils als LEDs ausgebildet sind, die im ultravioletten Spektralbereich zwischen 200 nm und 300 nm emittieren.

8. Korpuskularstrahlgerät nach mindestens einem der Ansprüche 1 - 6, wobei die mehreren Lichtquellen (115.1 - 115.5) als Austrittsflächen eines Faserbündels mit mehreren Lichtleitfasern ausgebildet und räumlich verteilt in der Säule (110) und/oder in der Vakuum-Probenkammer (120) platziert sind und am anderen Ende des Faserbündels eine Lichtquelle (150) angeordnet ist, über die eine Einkopplung von Licht in die einzelnen Lichtleitfasern des Faserbündels erfolgt und wobei zwischen der Lichtquelle (150) und den Lichtleitfasern mindestens eine faseroptische Schalteinheit (140) angeordnet ist, die über die Steuereinheit (130) zum zeitlich selektiven Ein- und Ausschalten einzelner Lichtleitfasern betätigbar ist.

9. Verfahren zum Betreiben eines Korpuskularstrahlgeräts mit einer Säule (10; 110), die eine Korpuskularstrahl-Optik umfasst, um darüber in einem Belichtungsbetrieb in einer Vakuum-Probenkammer (20; 120) ein gewünschtes Muster zu belichten,
- wobei zur Reinigung der Säule (10; 110) und/oder der Vakuum-Probenkammer (20; 120) in einem Reinigungsbetrieb über ein Gaszuführsystem der Säule (19; 110) und/oder der Vakuum-Probenkammer (20; 120) ein regulierbarer Gasstrom mit einem photodissoziierbarem Gas zugeführt wird und
- im Reinigungsbetrieb das zugeführte Gas mittels mehrerer in der Säule (10; 110) und/oder in der Vakuum-Probenkammer (20; 120) räumlich verteilt angeordneter Lichtquellen (15.1 - 15.5; 115.1 - 115.5) photodissoziiert wird, indem einzelne Lichtquellen (15.1 - 15.5; 115.1 - 115.5) über eine damit verbundene Steuereinheit (30; 130) zeitlich selektiv ein- und ausgeschaltet werden und
- wobei außerhalb der Säule (10; 110) ein Sauerstoff-Reservoir (1; 101) sowie ein Ozon-Generator (2; 102) angeordnet ist, über den aus dem Sauerstoff-Reservoir (1; 101) Ozon als photodissoziierbares Gas erzeugt und der Säule (10; 110) über das Gaszuführsystem zugeführt wird und wobei durch die Wechselwirkung zwischen der von den Lichtquellen (15.1 - 15.5; 115.1 - 115.5) emittierten Strahlung und dem Ozon Sauerstoffradikale als Photodissoziationsprodukte resultieren, die mit Verunreinigungen zu abpumpbaren Abbauprodukten reagieren.

10. Verfahren nach Anspruch 9, wobei die Steuereinheit (30; 130) desweiteren mit einem Einlassventil (3; 103) des Gaszuführsystems in Wirkverbindung steht und im Reinigungsbetrieb derart auf das Einlassventil (3; 103) einwirkt, dass der Gasdruck in der Säule (10; 110) und/oder in der Vakuum-Probenkammer (20; 120) definiert eingestellt wird.

11. Verfahren nach Anspruch 9, wobei über die Steuereinheit (30; 130) im Reinigungsbetrieb die zeitliche Aktivierung einzelner Lichtquellen (15.1 - 15.5; 115.1 - 115.5) in Abhängigkeit von der Verschmutzung in der Umgebung der jeweiligen Lichtquelle (15.1 - 15.5; 115.1 - 115.5) vorgenommen wird.

12. Verfahren nach Anspruch 9, wobei während des Reinigungsbetriebs der Korpuskularstrahl ausgeschaltet wird.

13. Verfahren nach Anspruch 9, wobei die aus der Reaktion der Photodissoziationsprodukte mit Verunreinigungen resultierenden Abbauprodukte über eine Vakuumpumpe (5; 105) abgesaugt werden.

14. Verfahren nach Anspruch 13, wobei die noch im Abpump-Gasstrom befindlichen Reste des photodissoziierbaren Gases abgebaut werden.

## Claims

1. Corpuscular beam device having
- a column (10; 110), which has a corpuscular beam optical unit for generating a corpuscular beam, in order to expose a desired pattern via this unit in an exposure mode in a vacuum sample chamber (20; 120),
- a gas supply system, in order to supply a controllable gas flow having a photo-dissociable gas via this system in a cleaning mode of the column (10; 110) and/or the vacuum sample chamber (20; 120), and
- multiple light sources (15.1 - 15.5; 115.1 - 115.5), which are arranged spatially distributed in the column (10; 110) and/or in the vacuum sample chamber (20; 120) and effectuate a photo-dissociation of the supplied gas in the cleaning mode, and
- a control unit (30; 130) connected to the light sources (15.1 - 15.5; 115.1 - 115.5), which is designed such that individual light sources (15.1 - 15.5; 115.1 - 115.5) can be switched on and off in a chronologically selective manner via this unit in the cleaning mode and
- wherein an oxygen reservoir (1; 101) and an ozone generator (2; 102) are arranged outside the column (10; 110), via which ozone can be generated as a photo-dissociable gas from the oxygen reservoir (1; 101) and can be supplied to the column (10; 110) via the gas supply system and wherein oxygen radicals result as photo-dissociation products, which react with contaminants to form breakdown products which can be pumped out, by way of the interaction between the radiation emitted by the light sources (15.1 - 15.5; 115.1 - 115.5) and the ozone.

2. Corpuscular beam device according to Claim 1, wherein the control unit (30; 130) is furthermore operationally connected to an inlet valve (3; 103) of the gas supply system and is designed such that the gas pressure in the column (10; 110) and/or in the vacuum sample chamber (20; 120) is settable in a targeted manner in the cleaning mode by acting on the inlet valve (3; 103).

3. Corpuscular beam device according to Claim 2, wherein a parameter set is stored in each case in the control unit (30; 130) for defined spatial regions of the column (10; 110) and/or the vacuum sample chamber (20; 120), which contains the required parameters for optimum cleaning of the respective region, and wherein the parameter set comprises at least the selection of one or more specific light sources (15.1 - 15.5; 115.1 - 115.5), the switching-on times thereof and a specific gas pressure in the column (10; 110) and/or in the vacuum sample chamber (20; 120).

4. Corpuscular beam device according to Claim 1, wherein the vacuum sample chamber (20; 1 20) is operationally connected to a vacuum pump (5; 105) to pump out resulting breakdown products from the reaction of the photo-dissociation products with contaminants and a conversion unit (4; 104), which breaks down residues of the photo-dissociable gas still located in the pumped-out gas flow, is arranged between the vacuum sample chamber (20; 120) and the vacuum pump (5; 105).

5. Corpuscular beam device according to Claim 1, wherein it has a corpuscular beam source (11; 111) arranged in the column (10; 110), in front of which a protective screen (12; 112) is arranged in order to protect the corpuscular beam source (11; 111) from a back-diffusion of photo-dissociation products.

6. Corpuscular beam device according to at least one of the preceding claims, wherein the light sources (15.1 - 15.5; 115.1 - 115.5) in the column (10; 110) and/or in the vacuum sample chamber (20; 120) are each arranged adjacent to elements which tend toward organic contamination.

7. Corpuscular beam device according to at least one of the preceding claims, wherein the light sources (15.1 - 15.5) are each designed as LEDs which emit in the ultraviolet spectral range between 200 nm and 300 nm.

8. Corpuscular beam device according to at least one of Claims 1 to 6, wherein the multiple light sources (115.1 - 115.5) are designed as exit surfaces of a fibre bundle having multiple optical fibres and are placed spatially distributed in the column (110) and/or in the vacuum sample chamber (120) and a light source (150) is arranged at the other end of the fibre bundle, via which coupling of light into the individual optical fibres of the fibre bundle occurs and wherein at least one fibre-optic switching unit (140) is arranged between the light source (150) and the optical fibres, which can be actuated via the control unit (130) for the chronologically selective switching on and off of individual optical fibres.

9. Method for operating a corpuscular beam device having a column (10; 110), which comprises a corpuscular beam optical unit, in order to expose a desired pattern in a vacuum sample chamber (20; 120) via this unit in an exposure mode,
- wherein a controllable gas flow having a photo-dissociable gas is supplied via a gas supply system of the column (19; 110) and/or the vacuum sample chamber (20; 120) for cleaning the column (10; 110) and/or the vacuum sample chamber (20; 120) in a cleaning mode and
- in the cleaning mode, the supplied gas is photo-dissociated by means of multiple light sources (15.1 - 15.5; 115.1 - 115.5) arranged spatially distributed in the column (10; 110) and/or in the vacuum sample chamber (20; 120), in that individual light sources (15.1 - 15.5; 115.1 - 115.5) are switched on and off in a chronologically selective manner via a control unit (30; 130) connected thereto and
- wherein an oxygen reservoir (1; 101) and an ozone generator (2; 102) are arranged outside the column (10; 110), via which ozone is generated as a photo-dissociable gas from the oxygen reservoir (1; 101) and supplied to the column (10; 110) via the gas supply system and wherein oxygen radicals result as photo-dissociation products, which react with contaminants to form breakdown products which can be pumped out, by way of the interaction between the radiation emitted by the light sources (15.1 - 15.5; 115.1 - 115.5) and the ozone.

10. Method according to Claim 9, wherein the control unit (30; 130) is furthermore operationally connected to an inlet valve (3; 103) of the gas supply system and acts on the inlet valve (3; 103) in the cleaning mode such that the gas pressure in the column (10; 110) and/or in the vacuum sample chamber (20; 120) is set in a defined manner.

11. Method according to Claim 9, wherein the chronological activation of individual light sources (15.1 - 15.5; 115.1 - 115.5) is performed in dependence on the soiling in the surroundings of the respective light source (15.1 - 15.5; 115.1 - 115.5) via the control unit (30; 130) in the cleaning mode.

12. Method according to Claim 9, wherein the corpuscular beam is switched off during the cleaning mode.

13. Method according to Claim 9, wherein the breakdown products resulting from the reaction of the photo-dissociation products with contaminants are suctioned off via a vacuum pump (5; 105).

14. Method according to Claim 13, wherein the residues of the photo-dissociable gas still found in the pumped-out gas flow are broken down.

## Revendications

1. Appareil de rayonnement corpusculaire, comprenant
- une colonne (10 ; 110) qui possède une optique de rayonnement corpusculaire destinée à générer un rayonnement corpusculaire afin d'exposer par le biais de celle-ci, dans un mode d'exposition, un motif souhaité dans une chambre à échantillons sous vide (20 ; 120),
- un système d'acheminement de gaz destiné à acheminer, par le biais de celui-ci dans un mode de nettoyage de la colonne (10 ; 110) et/ou de la chambre à échantillons sous vide (20 ; 120), un flux de gaz régulable comprenant un gaz photodissociable et
- plusieurs sources de lumière (15.1 - 15.5 ; 115.1 - 115.5), qui sont disposées distribuées dans l'espace dans la colonne (10 ; 110) et/ou dans la chambre à échantillons sous vide (20 ; 120) et, en mode de nettoyage, provoquent une photodissociation du gaz acheminé et
- une unité de commande (30 ; 130) reliée aux sources de lumière (15.1 - 15.5 ; 115.1 - 115.5), laquelle est configurée de telle sorte que par le biais de celui-ci dans le mode de nettoyage, les sources de lumière (15.1 - 15.5 ; 115.1 - 115.5) individuelles peuvent être allumée et éteintes sélectivement dans le temps et
- à l'extérieur de la colonne (10 ; 110) sont disposés un réservoir à oxygène (1 ; 101) ainsi qu'un générateur d'ozone (2 ; 102), par le biais desquels de l'ozone peut être généré à partir du réservoir à oxygène (1 ; 101) en tant que gaz photodissociable et peut être acheminé à la colonne (10 ; 110) par le biais du système d'acheminement de gaz et l'interaction entre le rayonnement émis par les sources de lumière (15.1 - 15.5 ; 115.1 - 115.5) et l'ozone produisant des radicaux d'oxygène en tant que produits de la photodissociation, lesquels réagissent avec des impuretés pour former des produits de décomposition pouvant être évacués par pompage.

2. Appareil de rayonnement corpusculaire selon la revendication 1, l'unité de commande (30 ; 130) se trouvant en outre en liaison fonctionnelle avec une vanne d'entrée (3 ; 103) du système d'acheminement de gaz et étant configurée de telle sorte que la pression de gaz dans la colonne (10 ; 110) et/ou dans la chambre à échantillons sous vide (20 ; 120) peut être réglée de manière ciblée en mode de nettoyage en agissant sur la vanne d'entrée (3 ; 103).

3. Appareil de rayonnement corpusculaire selon la revendication 2, un jeu de paramètres étant respectivement enregistré dans l'unité de commande (30 ; 130) pour des zones spatiales définies de la colonne (10 ; 110) et/ou de la chambre à échantillons sous vide (20 ; 120), lequel contient les paramètres nécessaires pour un nettoyage optimal de la zone respective et le jeu de paramètres comprenant au moins la sélection d'une ou plusieurs sources de lumière (15.1 - 15.5 ; 115.1 - 115.5) définies, leurs instants d'allumage et une pression de gaz définie dans la colonne (10 ; 110) et/ou dans la chambre à échantillons sous vide (20 ; 120).

4. Appareil de rayonnement corpusculaire selon la revendication 1, la chambre à échantillons sous vide (20 ; 120) se trouvant en liaison fonctionnelle avec une pompe à vide (5 ; 105) en vue d'évacuer par pompage les produits de décomposition résultants de la réaction des produits de photodissociation avec des impuretés et une unité de conversion (4 ; 104) étant disposée entre la chambre à échantillons sous vide (20 ; 120) et la pompe à vide (5 ; 105), laquelle décompose les résidus des gaz photodissociés encore présents dans le flux de gaz évacué par pompage.

5. Appareil de rayonnement corpusculaire selon la revendication 1, celui-ci possédant une source de rayonnement corpusculaire (11 ; 111) disposée dans la colonne (10 ; 110), devant laquelle est monté un écran protecteur (12 ; 112) afin de protéger la source de rayonnement corpusculaire (11 ; 111) contre une rétrodiffusion des produits de photodissociation.

6. Appareil de rayonnement corpusculaire selon au moins l'une des revendications précédentes, les sources de lumière (15.1 - 15.5 ; 115.1 - 115.5) dans la colonne (10 ; 110) et/ou dans la chambre à échantillons sous vide (20 ; 120) étant respectivement disposées voisines d'élément qui ont tendance à la contamination organique.

7. Appareil de rayonnement corpusculaire selon au moins l'une des revendications précédentes, les sources de lumière (15.1 - 15.5) étant respectivement réalisées sous forme de LED qui émettent dans la plage spectrale des ultraviolets entre 200 nm et 300 nm.

8. Appareil de rayonnement corpusculaire selon au moins l'une des revendications 1 à 6, les sources de lumière (115.1 - 115.5) étant réalisées sous la forme des surfaces de sortie d'un faisceau de fibres comprenant plusieurs fibres optiques et étant positionnées distribuées dans l'espace dans la colonne (110) et/ou dans la chambre à échantillons sous vide (120) et à l'autre extrémité du faisceau de fibres étant disposée une source de lumière (150) par le biais de laquelle est réalisé une injection de lumière dans les fibres optiques individuelles du faisceau de fibres et au moins une unité de commutation optique à fibres (140) étant disposée entre la source de lumière (150) et les fibres optiques, laquelle peut être actionnée par le biais de l'unité de commande (130) pour la mise en circuit et hors circuit sélective des fibres optiques individuelles.

9. Procédé pour faire fonctionner un appareil de rayonnement corpusculaire comprenant une colonne (10 ; 110), laquelle possède une optique de rayonnement corpusculaire destinée à générer un rayonnement corpusculaire afin d'exposer par le biais de celle-ci, dans un mode d'exposition, un motif souhaité dans une chambre à échantillons sous vide (20 ; 120),
- un flux de gaz régulable comprenant un gaz photodissociable étant acheminé à la colonne (10 ; 110) et/ou à la chambre à échantillons sous vide (20 ; 120) par le biais d'un système d'acheminement de gaz dans un mode de nettoyage en vue de nettoyer la colonne (19 ; 110) et/ou la chambre à échantillons sous vide (20 ; 120), et
- en mode de nettoyage, le gaz acheminé étant photodissocié au moyen de plusieurs sources de lumière (15.1 - 15.5 ; 115.1 - 115.5) disposées distribuées dans l'espace dans la colonne (10 ; 110) et/ou dans la chambre à échantillons sous vide (20 ; 120) par un allumage et une extinction sélectifs dans le temps des sources de lumière (15.1 - 15.5 ; 115.1 - 115.5) individuelles par le biais d'une unité de commande (30 ; 130) reliée à celles-ci et
- un réservoir à oxygène (1 ; 101) ainsi qu'un générateur d'ozone (2 ; 102) étant disposés à l'extérieur de la colonne (10 ; 110), par le biais desquels de l'ozone est généré à partir du réservoir à oxygène (1 ; 101) en tant que gaz photodissociable et acheminé à la colonne (10 ; 110) par le biais du système d'acheminement de gaz et l'interaction entre le rayonnement émis par les sources de lumière (15.1 - 15.5 ; 115.1 - 115.5) et l'ozone produisant des radicaux d'oxygène en tant que produits de la photodissociation, lesquels réagissent avec des impuretés pour former des produits de décomposition pouvant être évacués par pompage.

10. Procédé selon la revendication 9, l'unité de commande (30 ; 130) se trouvant en outre en liaison fonctionnelle avec une vanne d'entrée (3 ; 103) du système d'acheminement de gaz et agissant sur la vanne d'entrée (3 ; 103) en mode de nettoyage de telle sorte que la pression de gaz dans la colonne (10 ; 110) et/ou dans la chambre à échantillons sous vide (20 ; 120) est réglée de manière définie.

11. Procédé selon la revendication 9, l'activation dans le temps des sources de lumière (15.1 - 15.5 ; 115.1 - 115.5) individuelles en mode de nettoyage par le biais de l'unité de commande (30 ; 130) étant effectuée en fonction de l'encrassement dans l'environnement de la source de lumière (15.1 - 15.5 ; 115.1 - 115.5) respective.

12. Procédé selon la revendication 9, le rayonnement corpusculaire étant désactivé pendant le mode de nettoyage.

13. Procédé selon la revendication 9, les produits de décomposition résultants de la réaction des produits de photodissociation avec des impuretés étant aspirés par une pompe à vide (5 ; 105).

14. Procédé selon la revendication 13, les résidus des gaz photodissociés encore présents dans le flux de gaz évacué par pompage étant décomposés.
